# EUROPEAN PATENT SPECIFICATION

(11) **EP 4 582 819 B1**
(45) Date of publication and mention of the grant of the patent: **25.11.2026**
(21) Application number: 24305034.1
(22) Date of filing: 08.01.2024
(51) Int. Cl.: G01R 31/26, G01R 31/28, G01K 7/01

(54) **POWER MODULE HEALTH MONITORING THROUGH PERIODIC GATE CURRENT INJECTION WITH VARIABLE DURATION**
LEISTUNGSMODULGESUNDHEITSÜBERWACHUNG DURCH PERIODISCHE GATESTROMINJEKTION MIT VARIABLER DAUER
SURVEILLANCE DE LA SANTÉ D'UN MODULE DE PUISSANCE PAR INJECTION PÉRIODIQUE DE COURANT DE GRILLE À DURÉE VARIABLE

(43) Date of publication of application: 09.07.2025
(73) Proprietor: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: Degrenne, Nicolas, 35708 RENNES CÉDEX 7 (FR); Quemener, Vincent, 35708 RENNES CEDEX 7 (FR)
(74) Representative: Plasseraud IP

(56) References cited:
- WO-A1-2013/187207
- KALKER SVEN ET AL: "Degradation Diagnosis During Active Power Cycling via Frequency-Domain Thermal Impedance Spectroscopy", 2023 11TH INTERNATIONAL CONFERENCE ON POWER ELECTRONICS AND ECCE ASIA (ICPE 2023 - ECCE ASIA), THE KOREAN INSTITUTE OF POWER ELECTRONICS, 22 May 2023 (2023-05-22), pages 1342 - 1348, XP034403915, [retrieved on 20230823], DOI: 10.23919/ICPE2023-ECCEASIA54778.2023.10213859

## Description

### Technical Field

This disclosure pertains to the field of monitoring of the health of electronic power modules such as solid-state switching modules and concerns a power module health monitoring method through a periodic current injection gate, such current injection having a variable duration.

### Background Art

Power modules are subject to the wear-out degradation of their thermal interfaces between the power dies and the heat-sink. Example of interfaces are die solder, baseplate, solder or thermal grease. Monitoring the health of the thermal interfaces is required in qualification tests such as power cycling and in on-line applications, for protection of the electronic circuits, condition-based maintenance or predictive maintenance.

Most prior-art methods perform the estimation of the thermal resistance under constant loss and/or known loss amplitude conditions. Knowing the loss amplitude is especially difficult in on-line applications when the losses depend on device characteristics, environment (e.g., gate resistance, parasitic components) and operating conditions (e.g., current, voltage, temperature) which vary over time.

Other prior-art methods depending on loss profile or loss frequency were thus researched. Such methods rely on periodic losses, temperature response, and correlating both signals to estimate a phase shift of a relevant parameter at an excitation frequency. These methods are thus insensitive to measurement errors in loss amplitude and/or temperatures amplitude but the periodic losses need to be synchronized with the measured temperature. If the periodic losses are generated by the normal operation in the application, an image of the losses (e.g., current) should be measured and synchronized with the temperature measures. Alternatively, the periodic losses may be injected on purpose during a diagnostic sequence.

In the prior art, health monitoring of thermal interfaces usually requires an estimation of the amplitude of the losses using complex sensors and/or electro-thermal models. Moreover, the monitoring technics may be intrusive and may impact the operation of the power modules and are not applicable to any mission profile (e.g. generated losses profiles). Finally, theses technics remain complex to implement, may use distinct hardware for excitation and measure and may be inaccurate, e.g. the synchronization is not precise. As a result, these methods are typically not implemented in commercial products.

In the domain, document KALKER SVEN ET AL: "Degradation Diagnosis During Active Power Cycling via Frequency-Domain Thermal Impedance Spectroscopy", 11th INTERNATIONAL CONFERENCE ON POWER ELECTRONICS AND ECCE ASIA (ICPE 2023 - ECCE ASIA), THE KOREAN INSTITUTE OF POWER ELECTRONICS, 22 May 2023, pages 1342-1348, DOI: 10.23919/ICPE2023-ECCEASIA54778.2023.10213859 proposes online thermal impedance spectroscopy in frequency domain for aging diagnosis during active power cycling of power electronics components.

### Summary

This disclosure improves the situation in proposing a method to generate losses in a power module and monitor the temperature in order to monitor degradation of the electro-thermal characteristics of the power module which is simpler and more accurate than the prior art methods.

The present disclosure then proposes a method and circuit that combines periodic losses injection and die temperature measurement Tj in a power device such that an IGBT or a MOSFET to monitor at least one of its thermal interfaces.

More precisely, the present invention concerns a method for measuring a degradation of thermal characteristics of a power module comprising sequences of:
- injecting current pulses, having a voltage-clamped constant amplitude, between an emitter and a gate of a power semiconductor of said power module, a duration of said voltage-clamped constant amplitude current pulses being modulated periodically with a modulation frequency, said current pulses causing losses modulated with said modulation frequency, and
- measuring a parameter dependent of a junction temperature of said power semiconductor at the beginning of said current pulses, and
- measuring a phase shift between said modulation frequency and said parameter,
said phase shift Δφ providing a health indicator for the power module.

This is based on the fact that the junction temperature is dependent on the losses which are modulated by the frequency modulating the current pulses duration and will then be consequently modulated by such frequency with a phase shift due to the dissipation of heat through the heatsink of the power semiconductor die and intermediate layers between such semiconductor die and such heatsink.

In the present case, the junction temperature may be estimated by measuring the voltage response which reflects a temperature-sensitive element, i.e., an internal element such as a built-in gate resistor and provides the parameter.

The synergy between measurements of the junction temperature and the periodic injection of current modulation allows for using the measurements whatever the mission profile. That is for any load current or switching PWM, providing an independent, easy-to-implement and accurate health monitoring of a selected thermal interface such as die solder.

The following features, can be optionally implemented, separately or in combination one with the others:
A lock-in method may be used to determine said phase-shift.

Such a method provides a precise result.

A temperature-dependent response of said power semiconductor being the junction temperature of said power semiconductor, said method may comprise determining a peak injection time issued from said modulation frequency, and measuring said phase shift as being a phase shift between a peak of said modulation frequency and a subsequent occurrence of a peak junction temperature.

This uses the shape of the modulation curve as a starting point for the measurement.

A temperature-dependent response of said power semiconductor being the junction temperature of said power semiconductor, said method may comprise determining a peak injection time from said modulation frequency, and measuring said phase shift as being a phase shift between a start or an end of said peak injection time and a subsequent occurrence of a peak junction temperature.

This uses the current injection pulses as a starting point for the measurement.

The method may comprise providing an initial sequence of injections of said constant current and measuring an initial phase shift in an initial operation stage of said power module, storing said initial phase shift duration as a reference for further sequences.

The method may comprise providing further sequences of injections of said constant current from time to time during the operational life of the power module and wherein a current phase shift at said further sequences is compared to said initial phase shift to provide a warning signal when said current phase shift is reduced to a preestablished percentage of said initial phase shift.

Said sequences may be repeated using different modulation frequencies to address different thermal interfaces within said power module.

Said modulation frequency may be sinusoidal.

Said voltage-clamped constant amplitude current may be a current of an amplitude within the range of 20mA to 200mA.

Said injecting a constant current may have a duration of at least 0,01 µs.

Said constant current may be set to increase the conduction loss in the power semiconductor up to 40%.

Injecting voltage-clamped constant amplitude current pulses may be done during at least parts of successive ON states of alternances of a switching frequency of said power semiconductor during a period of the modulation frequency.

Said modulation frequency may be at least one order of magnitude lower than said switching frequency of said power semiconductor.

Injecting voltage-clamped constant amplitude current pulses may be done during non-switching OFF state periods of said power semiconductor.

Injecting voltage-clamped constant amplitude current pulses may have a limited duration to limit the voltage-clamp duration and an injection frequency equal or higher than 100 kHz.

Said modulation frequency may be at least one order of magnitude lower than said injection frequency.

Said sequences may be repeated on several power semiconductors of said power module from time to time during the operational life of the power module.

Said sequences may be repeated during several modulation periods being the inverse of the modulation frequency and may comprise averaging the measurements at identical injection phases to reduce noise and allow for a sensitive health indication of said power module.

### Brief Description of Drawings

Other features, details and advantages will be shown in the following detailed description and on the figures, on which:
Figure 1 shows a simplified schematic of a circuit providing periodic current pulses injection;
Figure 2 shows curves of a first embodiment of the method;
Figure 3 shows curves of a second embodiment of the method;
Figures 4A and 4B show details of pulses at two different positions on a modulating frequency curve;
Figure 5 is an example of simplified lock-in schematics.

### Description of Embodiments

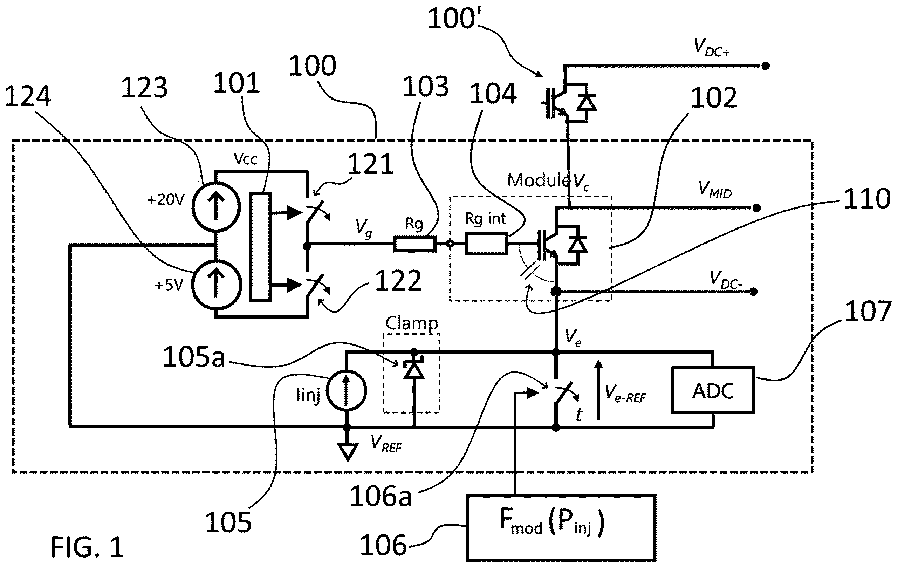

It is now referred to figure 1 which shows an example of possible implementation of a driver circuit for a semiconductor switch 102 in a lower arm 100 of a half bridge having an upper arm 100' where only the semiconductor switch is represented.

The driver circuit comprises gate switches 121, 122 switching power supplies 123, 124 under control of a controller 101 to provide switching of the power semiconductor switch 102. In the example shown the positive power supply 123 is a 20V power supply but may be different depending of the semiconductor switch type and the negative power supply 124 is a 5V power supply that allows to block the semiconductor switch, here also such voltage may be different depending of the semiconductor switch type.

In the present disclosure is provided a current generator 105 providing a current Iᵢₙⱼ such current generator being switched ON and OFF by a switch 106a driven through a modulator 106 modulating switch pulse durations.

The current pulses are clamped by a clamp diode 105a to provide sequences of injecting current pulses Pᵢₙⱼ having a voltage-clamped constant amplitude Iᵢₙⱼ, between an emitter and a gate of the power semiconductor 102.

The duration of the current pulses Pᵢₙⱼ with voltage-clamped constant amplitude Iᵢₙⱼ is modulated periodically with a frequency F_{mod} providing a periodic modulation of a duration of said current pulses, said current pulses causing losses modulated with said frequency F_{mod}.

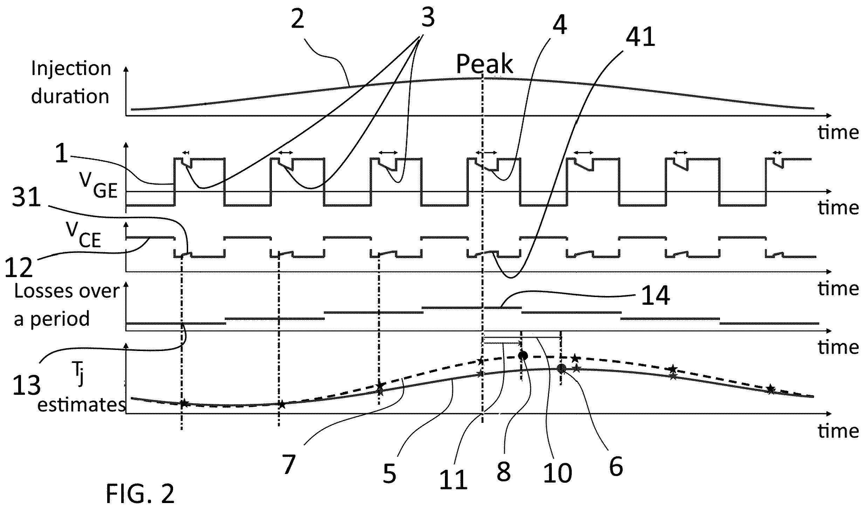

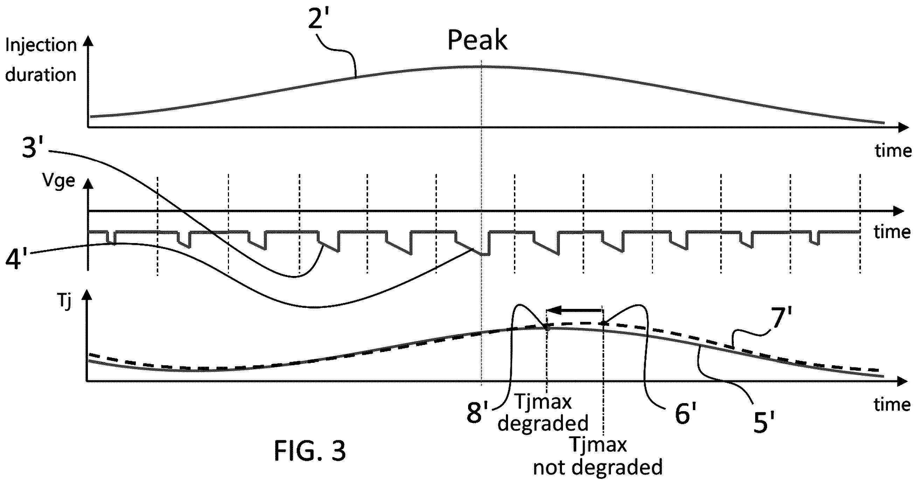

An example of sequences of injecting the current pulses during operation of the semiconductor switch are shown in figure 2 while a sequence of injecting the current pulses during OFF state of the semiconductor switch are shown in figure 3.

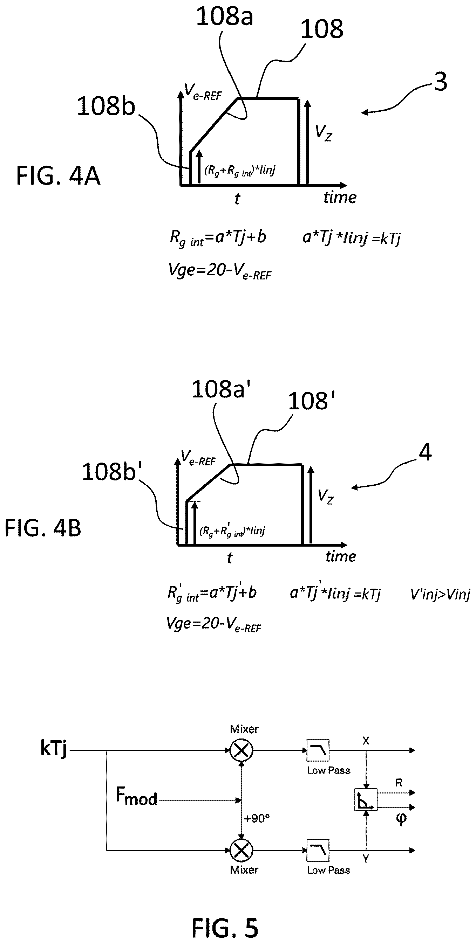

Measurement of the emitter voltage Vₑ versus the reference voltage of the semiconductor switch is done through an analog to digital converter ADC 107 and this voltage during the current pulse is shown in figure 4A for a first pulse 3 where said voltage has a vertical part 108b caused by the internal gate resistance which is temperature-sensitive, a positive slope 108a caused by the charging of the parasitic capacitor 110 and a straight part 108 for the rest of the duration of the pulse corresponding to the Zener diode clamping voltage V_{Z}.

The parameter k·Tj dependent of a junction temperature Tj of the power semiconductor can be measured by acquiring the voltage response at the very early stage of the positive slope 108a in figure 4A, or 108a' in figure 4B, or by measuring two points on the positive slope 108a, 108a' and extrapolating the starting point of such slope at the starting point of the injection. Alternatively, it may be advantageous to measure the parameter k·Tj as the peak value of a short pulse, typically in the range 0.01µs to 0.2µs. In this case, the pulse for measuring the parameter k·Tj may be distinct from the periodically modulated pulse. In figure 4A, the constant providing the temperature dependent part of R_{G-int} is a·Iᵢₙⱼ=k.

As shown on the figure, the gate to emitter voltage V_{GE} is equal to 20-V_{e-REF} during positive switching periods where the positive voltage 123 is switched by the driver switch 121.

This can be seen on figure 2 where are represented:
a. - the semiconductor switching pulses 1, having injected current pulses 3 and the larger current pulse 4,
b. - the modulating frequency F_{mod} 2 which modulates the width of the constant current pulses;
c. The V_{GE} curve 1 of the power semiconductor showing gate voltage reductions during the on-state of the power semi-conductor, with increased reduction time when the injection duration is increased. In addition, not visible in Fig. 2, the V_{GE} waveform during the injection reflects the temperature response. This can be seen in Figures 4A and 4B showing the voltage V_{e-REF} inverted with reference to V_{GE} and where the height of the initial voltages 108b and 108b' increases between a first current injection in figure 4A and a further current injection in figure 4B. This is an important feature of an embodiment of the invention since the injection is both used to modulate the losses through modulating the injection duration and monitoring the temperature response reflected by the height of the initial voltage increase upon switching ON the current Iᵢₙⱼ;
d. - the V_{CE} curve 12 of the power semiconductor showing that the on-state voltage of the semiconductor switch is increased 31, 41 during occurrences of the current pulses 3,4 causing losses in the power semiconductor. Curve 13 shows the mean losses on a switching period, such losses increasing until a peak 14 due to the peak injection duration and decreasing after such peak injection duration;
e. - a first junction temperature curve 5 for a power semiconductor switch without degraded die to heatsink connection;
f. - a second junction temperature curve 7 for a power semiconductor switch with a degraded die to heatsink connection.

As can be seen on the drawing the first junction temperature has a lower temperature peak 6 than the second junction temperature which has a higher temperature peak 8. However, the amplitude of the peak temperature may not be accurate since working conditions may affect these peak values.

The junction temperature Tj will evolve from the first shorter pulse 3 to the larger pulse 4 due to the modulating frequency F_{mod}. Such evolution is exemplified in figures 4A and 4B corresponding to the evolution of V_{e-REF} which is inverted with respect to V_{GE} during the current injection pulses. In figure 4A, the smallest value of Vᵢₙⱼ , the height of the vertical segment 108b corresponds to (R_{g}+R_{g int})·Iᵢₙⱼ where R_{g} is the external gate resistance in figure 1 and R_{g int} is the internal gate resistance which is variable with temperature such as R_{g int=} a·Tⱼ+b where aTj·Iᵢₙⱼ=kTⱼ.

Figure 4B shows the pulse shape for the larger injection pulse 4. In such case the vertical segment 108b' is higher due to the successive increase of losses and R'_{g-int=} a·T'ⱼ+b where a T'j·Iᵢₙⱼ=kT'ⱼ, T'>T.
In figures 4A and 4B the voltage V_{e-REF} starts at the value (R_{g}+ R_{g int})·Iᵢₙⱼ and increases with slopes 108a, 108a' due to the charging of the gate/emitter capacitor 110.
When the capacitor 110 is charged, the voltage 108, 108' is constant at the Zener voltage value.
The height of the vertical segments 108b and 108b' allow to calculate the kTⱼ, kT'ⱼ component of R_{g int} which permits to determine Tⱼ, T'ⱼ at the start of the current injection pulses 3 and 4.

Knowing the kTⱼ values of the injection pulses permits to construct junction temperature curves 5 and 7 on the basis of an interpolation of the kTⱼ values calculated for each of the injection pulses 3.

In one implementation of the present disclosure, the phase is extracted with a lock-in method (known by the person skilled in the art) as shown in figure 5. The temperature estimation signal kTⱼ 5, 7 is multiplied by the modulation frequency F_{mod} signal 2 and a 90°C phase-shifted version of the modulation frequency F_{mod} signal 2 of figure 2. The results of these two multiplications are filtered with low-pass filters to reject the noise and the 4π·F_{mod} component and finally converted to polar coordinates R amplitude which is not used in the present disclosure and φ the phase which corresponds to the Δφ between F_{mod} and the kTⱼ signal.

In another implementation of the present disclosure, further to the current injection an idea is to use the delay between the occurrence of a peak duration of the current pulses and the occurrence of the peak temperature, such delay being an accurate image of the degradation of the semiconductor to heatsink stack. In the exemplified situation, a good stack quality result in a lower peak temperature 6 and a higher delay 10 between occurrence of the peak duration 4 of the current injection and the peak junction temperature in the semiconductor die, while a degraded stack will provide a shorter delay between occurrence of the peak duration 4 of the current injection and the peak junction temperature 8.

Triggering of the measurement of the delay may be done with the peak of the Tⱼ reconstructed curve, the starting point of the larger current injection pulse 4 or the end of such current injection pulse.

The measurement of the delay is done with a processor such as a microcontroller or a FPGA having analog to digital input means. Such processor may be the processor implementing the program controlling the semiconductor switch to which will be added instructions to implement the modulated current injection 106 and control of the injection switch 106a.

In the realization mode discussed hereabove, the current injection is done during switching of the semiconductor switch.

Another possible implementation is in accordance with the curves of figure 3 which correspond to a situation where the current injection pulses are applied during OFF state of the semiconductor switch. In this implementation, the losses are directly created by the gate current injected in the internal gate resistance, by Joule effect. The semiconductor switch is not necessarily switching, i.e. it can be in standby mode, at zero load current.

In such case, the modulation curve 2' provides injection pulses 3', 4' also having a modulated duration. Such pulses also provide vertical voltage segments having a height dependent on the junction temperature which increase in correspondence with the pulses duration modulated by the modulation frequency curve 2.

The voltage clamped constant amplitude Iᵢₙⱼ current pulses Pᵢₙⱼ have a limited duration to limit the voltage-clamp duration and an injection frequency Fᵢₙⱼ equal or higher than 100 kHz to be higher than a switching frequency of the power module.

Here, the modulation frequency F_{mod} is also at least one order of magnitude lower than said injection frequency Fᵢₙⱼ to provide a sufficient number.

If the power module comprises several power switches, the sequences are repeated on said several power semiconductors of said power module from time to time during the operational life of the power module.

In order to reduce noise effects, the sequences are repeated during several periods T_{mod}=1/F_{mod} and the measurements at identical injections phases are averaged, that is the first injections of different periods are averaged together, the second injections of different periods are averaged together and the p injections of different periods are averaged together. This allows for a sensitive health indication of said power module.

The sequences may be repeated using different injection frequencies to address different thermal interfaces within said power module. For example, depending on the power module, frequencies between 10Hz and 100Hz may be used with respect to die-attach and wire degradation, frequencies between 1Hz and 10Hz may be used with respect to the delamination between the isolated direct bond copper (DBC) and the baseplate, and frequencies below 1Hz may be used with respect to the degradation of the thermal interface material such as thermal grease pump-out.

This disclosure is not limited to the description above which are only examples. The invention is defined by the appended claims.

## Claims

1. - Method for measuring a degradation of thermal characteristics of a power module comprising sequences of:
- injecting current pulses (Pᵢₙⱼ), having a voltage-clamped constant amplitude (Iᵢₙᵢ), between an emitter and a gate of a power semiconductor (102) of said power module, a duration of said voltage-clamped constant amplitude (Iᵢₙⱼ) current pulses (Pᵢₙⱼ) being modulated periodically with a modulation frequency (F_{mod}), said current pulses causing losses modulated with said modulation frequency (F_{mod}), and
- measuring a parameter (k·Tj) dependent of a junction temperature (Tj) of said power semiconductor (102) at the beginning of said current pulses, and
- measuring a phase shift (Δφ) between said modulation frequency (F_{mod}) and said parameter (k·Tj), said phase shift (Δφ) providing a health indicator for the power module.

2. Method according to claim 1 wherein a lock-in method is used to determine said phase-shift (Δφ).

3. - Method according to claim 1 or 2 wherein a temperature-dependent response of said power semiconductor (102) being the junction temperature of said power semiconductor, said method comprises determining a peak injection time issued from said modulation frequency, and measuring said phase shift (Δφ) as being a phase shift between a peak of said modulation frequency (F_{mod}) and a subsequent occurrence of a peak junction temperature (Tjₘₐₓ).

4. - Method according to claim 1 wherein a temperature-dependent response of said power semiconductor (102) being the junction temperature of said power semiconductor, said method comprises determining a peak injection time from said modulation frequency, and measuring said phase shift (Δφ) as being a phase shift between a start or an end of said peak injection time and a subsequent occurrence of a peak junction temperature (Tjₘₐₓ).

5. - Method according to any one of the preceding claims comprising providing an initial sequence of injections of said constant current (Iᵢₙⱼ) and measuring an initial phase shift (Δφ₀) in an initial operation stage of said power module, storing said initial phase shift duration as a reference for further sequences and providing further sequences of injections of said constant current (Iᵢₙⱼ) from time to time during the operational life of the power module and wherein a current phase shift (Δφ) at said further sequences is compared to said initial phase shift (Δφ₀) to provide a warning signal when said current phase shift (Δφ) is reduced to a preestablished percentage of said initial phase shift (Δφ₀).

6. - Method according to claim 5 wherein said sequences are repeated using different modulation frequencies to address different thermal interfaces within said power module.

7. - Method according to any one of the preceding claims wherein said modulation frequency (F_{mod}) is sinusoidal.

8. - Method according to any one of the preceding claims wherein injecting a constant current may have at least one of:
- said voltage-clamped constant amplitude current (Iᵢₙⱼ) is a current of an amplitude within the range of 20mA to 200mA.
- said injecting a constant current has a duration of at least 0,01 µs.
- said constant current is set to increase the conduction loss in the power semiconductor up to 40%.

9. - Method according to any one of the preceding claims wherein injecting voltage-clamped constant amplitude (Iᵢₙⱼ) current pulses (Pᵢₙⱼ) is done during at least parts of successive ON states of alternances of a switching frequency (Fs) of said power semiconductor (102) during a period of the modulation frequency.

10. - Method according to claim 9 wherein said modulation frequency (F_{mod}) is at least one order of magnitude lower than said switching frequency of said power semiconductor(102).

11. - Method according to any one of claims 1 to 10 wherein injecting voltage-clamped constant amplitude (Iᵢₙⱼ) current pulses (Pᵢₙⱼ) is done during non-switching OFF state periods of said power semiconductor(102).

12. - Method according to claim 11 wherein injecting voltage-clamped constant amplitude (Iᵢₙⱼ) current pulses (Pᵢₙⱼ) has a limited duration to limit the voltage-clamp duration and an injection frequency (Fᵢₙⱼ) equal or higher than 100 kHz.

13. - Method according to claim 11 or 12 wherein said modulation frequency (F_{mod}) is at least one order of magnitude lower than said injection frequency (Fᵢₙⱼ).

14. - Method according to any one of the preceding claims wherein said sequences are repeated during several modulation periods being the inverse of the modulation frequency (T_{mod}=1/F_{mod}) and comprise averaging the measurements at identical injection phases to reduce noise and allow for a sensitive health indication of said power module.

15. - Method according to any one of the preceding claims wherein said sequences are repeated on several power semiconductors (102) of said power module from time to time during the operational life of the power module.

## Patentansprüche

1. Verfahren zum Messen einer Degradierung von thermischen Eigenschaften eines Leistungsmoduls, welches Sequenzen umfasst aus:
- Einspeisen von Stromimpulsen (Pᵢₙⱼ), welche eine spannungsgeklemmte konstante Amplitude (Iᵢₙⱼ) aufweisen, zwischen einem Emitter und einem Gate eines Leistungshalbleiters (102) des Leistungsmoduls, wobei eine Dauer der Stromimpulse (Pᵢₙⱼ) mit spannungsgeklemmter konstanter Amplitude (Iᵢₙⱼ) periodisch mit einer Modulationsfrequenz (F_{mod}) moduliert wird, wobei die Stromimpulse Verluste verursachen, welche mit der Modulationsfrequenz (F_{mod}) moduliert werden, und
- Messen eines Parameters (k·Tj), welcher von einer Übergangstemperatur (Tj) des Leistungshalbleiters (102) zu Beginn der Stromimpulse abhängig ist, und
- Messen einer Phasenverschiebung (Δφ) zwischen der Modulationsfrequenz (F_{mod}) und dem Parameter (k·Tj),
wobei die Phasenverschiebung (Δφ) einen Zustandsindikator für das Leistungsmodul bereitstellt.

2. Verfahren nach Anspruch 1, wobei ein Lock-in-Verfahren verwendet wird, um die Phasenverschiebung (Δφ) zu bestimmen.

3. Verfahren nach Anspruch 1 oder 2, wobei eine temperaturabhängige Reaktion des Leistungshalbleiters (102) die Übergangstemperatur des Leistungshalbleiters ist, wobei das Verfahren ein Bestimmen eines Spitzeneinspeisung-Zeitpunkts, welcher aus der Modulationsfrequenz abgeleitet wird, und ein Messen der Phasenverschiebung (Δφ) als eine Phasenverschiebung zwischen einem Spitzenwert der Modulationsfrequenz (F_{mod}) und einem nachfolgenden Auftreten einer Spitzenwert-Übergangstemperatur (Tjₘₐₓ) umfasst.

4. Verfahren nach Anspruch 1, wobei eine temperaturabhängige Reaktion des Leistungshalbleiters (102) die Übergangstemperatur des Leistungshalbleiters ist, wobei das Verfahren ein Bestimmen eines Spitzeneinspeisung-Zeitpunkts aus der Modulationsfrequenz und ein Messen der Phasenverschiebung (Δφ) als eine Phasenverschiebung zwischen einem Beginn oder einem Ende des Spitzeneinspeisung-Zeitpunkts und einem nachfolgenden Auftreten einer Spitzenwert-Übergangstemperatur (Tjₘₐₓ) umfasst.

5. Verfahren nach einem der vorhergehenden Ansprüche, umfassend ein Bereitstellen einer anfänglichen Sequenz von Einspeisungen des konstanten Stroms (Iᵢₙⱼ) und ein Messen einer anfänglichen Phasenverschiebung (Δφ₀) in einer anfänglichen Betriebsphase des Leistungsmoduls, ein Speichern der anfänglichen Phasenverschiebungsdauer als eine Referenz für weitere Sequenzen und ein Bereitstellen weiterer Sequenzen von Einspeisungen des konstanten Stroms (Iᵢₙⱼ) von Zeit zu Zeit während der Betriebslebensdauer des Leistungsmoduls, und wobei eine aktuelle Phasenverschiebung (Δφ) bei den weiteren Sequenzen mit der anfänglichen Phasenverschiebung (Δφ₀) verglichen wird, um ein Warnsignal bereitzustellen, wenn die aktuelle Phasenverschiebung (Δφ) auf einen vorbestimmten Prozentsatz der anfänglichen Phasenverschiebung (Δφ₀) reduziert wird.

6. Verfahren nach Anspruch 5, wobei die Sequenzen unter Verwendung unterschiedlicher Modulationsfrequenzen wiederholt werden, um unterschiedliche thermische Grenzflächen innerhalb des Leistungsmoduls anzusprechen.

7. Verfahren nach einem der vorhergehenden Ansprüche, wobei die Modulationsfrequenz (F_{mod}) sinusförmig ist.

8. Verfahren nach einem der vorhergehenden Ansprüche, wobei das Einspeisen eines konstanten Stroms wenigstens eines aufweisen kann aus:
- der spannungsgeklemmte konstante Amplitudenstrom (Iᵢₙⱼ) ist ein Strom einer Amplitude innerhalb des Bereichs von 20 mA bis 200 mA;
- das Einspeisen eines konstanten Stroms weist eine Dauer von wenigstens 0,01 µs auf;
- der konstante Strom ist eingestellt, um den Leitungsverlust in dem Leistungshalbleiter um bis zu 40 % zu erhöhen.

9. Verfahren nach einem der vorhergehenden Ansprüche, wobei das Einspeisen von Stromimpulsen (Pᵢₙⱼ) mit spannungsgeklemmter konstanter Amplitude (Iᵢₙⱼ) während zumindest von Teilen aufeinanderfolgender AN-Zustände von Halbwellen einer Schaltfrequenz (Fs) des Leistungshalbleiters (102) während einer Periode der Modulationsfrequenz erfolgt.

10. Verfahren nach Anspruch 9, wobei die Modulationsfrequenz (F_{mod}) wenigstens eine Größenordnung niedriger ist als die Schaltfrequenz des Leistungshalbleiters (102).

11. Verfahren nach einem der Ansprüche 1 bis 10, wobei das Einspeisen von Stromimpulsen (Pᵢₙⱼ) mit spannungsgeklemmter konstanter Amplitude (Iᵢₙⱼ) während Perioden des nicht schaltenden AUS-Zustands des Leistungshalbleiters (102) erfolgt.

12. Verfahren nach Anspruch 11, wobei das Einspeisen von Stromimpulsen (Pᵢₙⱼ) mit spannungsgeklemmter konstanter Amplitude (Iᵢₙⱼ) eine begrenzte Dauer aufweist, um die Spannungsklemmungsdauer zu begrenzen, und eine Einspeisungsfrequenz (Fᵢₙⱼ) gleich oder höher als 100 kHz aufweist.

13. Verfahren nach Anspruch 11 oder 12, wobei die Modulationsfrequenz (F_{mod}) wenigstens eine Größenordnung niedriger ist als die Einspeisungsfrequenz (Fᵢₙⱼ).

14. Verfahren nach einem der vorhergehenden Ansprüche, wobei die Sequenzen während mehrerer Modulationsperioden, welche der Kehrwert der Modulationsfrequenz sind (T_{mod}=1/F_{mod}), wiederholt werden und ein Bilden eines Mittelwerts der Messungen bei identischen Einspeisungsphasen umfassen, um Rauschen zu reduzieren und eine empfindliche Zustandsanzeige des Leistungsmoduls zu ermöglichen.

15. Verfahren nach einem der vorhergehenden Ansprüche, wobei die Sequenzen von Zeit zu Zeit während der Betriebslebensdauer des Leistungsmoduls an mehreren Leistungshalbleitern (102) des Leistungsmoduls wiederholt werden.

## Revendications

1. Procédé de mesure d'une dégradation de caractéristiques thermiques d'un module de puissance comprenant des séquences de :
- injection d'impulsions de courant (Pᵢₙⱼ), présentant une amplitude constante à tension imposée (Iᵢₙⱼ), entre un émetteur et une grille d'un semi-conducteur de puissance (102) dudit module de puissance, une durée desdites impulsions de courant (Pᵢₙⱼ) d'amplitude constante à tension imposée (Iᵢₙⱼ) étant modulée périodiquement avec une fréquence de modulation (F_{mod}), lesdites impulsions de courant provoquant des pertes modulées avec ladite fréquence de modulation (F_{mod}), et
- mesure d'un paramètre (k·Tj) dépendant d'une température de jonction (Tj) dudit semi-conducteur de puissance (102) au début desdites impulsions de courant, et
- mesure d'un décalage de phase (Δφ) entre ladite fréquence de modulation (F_{mod}) et ledit paramètre (k·Tj),
ledit décalage de phase (Δφ) fournissant un indicateur de santé concernant le module de puissance.

2. Procédé selon la revendication 1, dans lequel une méthode de détection synchrone sert à déterminer ledit décalage de phase (Δφ).

3. Procédé selon la revendication 1 ou 2, dans lequel une réponse, dépendante de la température, dudit semi-conducteur de puissance (102) étant la température de jonction dudit semi-conducteur de puissance, ledit procédé comprend la détermination d'un temps d'injection maximal issu de ladite fréquence de modulation, et la mesure dudit décalage de phase (Δφ) comme étant un décalage de phase entre un pic de ladite fréquence de modulation (F_{mod}) et une occurrence ultérieure d'une température de jonction maximale (Tjₘₐₓ).

4. Procédé selon la revendication 1, dans lequel une réponse, dépendante de la température, dudit semi-conducteur de puissance (102) étant la température de jonction dudit semi-conducteur de puissance, ledit procédé comprend la détermination d'un temps d'injection maximal à partir de ladite fréquence de modulation, et la mesure dudit décalage de phase (Δφ) comme étant un décalage de phase entre un début ou une fin dudit temps d'injection maximal et une occurrence ultérieure d'une température de jonction maximale (Tjₘₐₓ).

5. Procédé selon l'une quelconque des revendications précédentes, comprenant la fourniture d'une séquence initiale d'injections dudit courant constant (lᵢₙⱼ) et la mesure d'un décalage de phase initial (Δφ₀) dans une phase de fonctionnement initiale dudit module de puissance, le stockage de ladite durée de décalage de phase initial comme référence pour d'autres séquences et la fourniture d'autres séquences d'injections dudit courant constant (Iᵢₙⱼ) de temps à autre pendant la durée de vie opérationnelle du module de puissance, et dans lequel un décalage de phase actuel (Δφ) au niveau desdites autres séquences est comparé audit décalage de phase initial (Δφ₀) afin de fournir un signal d'avertissement lorsque ledit décalage de phase actuel (Δφ) est réduit à un pourcentage préétabli dudit décalage de phase initial (Δφ₀).

6. Procédé selon la revendication 5, dans lequel lesdites séquences sont répétées en utilisant différentes fréquences de modulation pour aborder différentes interfaces thermiques au sein dudit module de puissance.

7. Procédé selon l'une quelconque des revendications précédentes, dans lequel ladite fréquence de modulation (F_{mod}) est sinusoïdale.

8. Procédé selon l'une quelconque des revendications précédentes, dans lequel l'injection d'un courant constant peut présenter au moins l'un des éléments suivants :
- ledit courant d'amplitude constante à tension imposée (Iᵢₙⱼ) est un courant d'une amplitude comprise dans la plage de 20 mA à 200 mA.
- ladite injection d'un courant constant présente une durée d'au moins 0,01 µs.
- ledit courant constant est fixé pour augmenter la perte de conduction dans le semi-conducteur de puissance jusqu'à 40 %.

9. Procédé selon l'une quelconque des revendications précédentes, dans lequel l'injection d'impulsions de courant (Pᵢₙⱼ) d'amplitude constante à tension imposée (Iᵢₙⱼ) est effectuée durant au moins certaines parties d'états activés successifs d'alternances d'une fréquence de commutation (Fs) dudit semi-conducteur de puissance (102) pendant une période de la fréquence de modulation.

10. Procédé selon la revendication 9, dans lequel ladite fréquence de modulation (F_{mod}) est d'au moins un ordre de grandeur inférieure à ladite fréquence de commutation dudit semi-conducteur de puissance (102).

11. Procédé selon l'une quelconque des revendications 1 à 10, dans lequel l'injection d'impulsions de courant (Pᵢₙⱼ) d'amplitude constante à tension imposée (Iᵢₙⱼ) est effectuée pendant des périodes d'état désactivé non commutées dudit semi-conducteur de puissance (102).

12. Procédé selon la revendication 11, dans lequel l'injection d'impulsions de courant (Pᵢₙⱼ) d'amplitude constante à tension imposée (Iᵢₙⱼ) présente une durée limitée afin de limiter la durée de tension imposée et une fréquence d'injection (Fᵢₙⱼ) égale ou supérieure à 100 kHz.

13. Procédé selon la revendication 11 ou 12, dans lequel ladite fréquence de modulation (F_{mod}) est d'au moins un ordre de grandeur inférieure à ladite fréquence d'injection (Fᵢₙⱼ).

14. Procédé selon l'une quelconque des revendications précédentes, dans lequel lesdites séquences sont répétées pendant plusieurs périodes de modulation représentant l'inverse de la fréquence de modulation (T_{mod}=1/F_{mod}) et comprennent le calcul d'une moyenne des mesures à des phases d'injection identiques pour réduire le bruit et permettre une indication sensible de santé dudit module de puissance.

15. Procédé selon l'une quelconque des revendications précédentes, dans lequel lesdites séquences sont répétées sur plusieurs semi-conducteurs de puissance (102) dudit module de puissance, de temps à autre, pendant la durée de vie opérationnelle du module de puissance.
